# EUROPEAN PATENT APPLICATION

(11) **EP 4 716 403 A1**
(43) Date of publication of application: **25.03.2026**
(21) Application number: 24383006.4
(22) Date of filing: 20.09.2024
(51) Int. Cl.: H10D 10/01, H10D 10/00, H10D 62/80, H10D 10/80, H10D 10/60, B82Y 10/00

(54) **AN ELECTRONIC DEVICE**

(71) Applicant: Universitat de València, 46010 Valencia (ES)
(72) Inventor: SÁNCHEZ ROYO, Juan Francisco, 46010 València (ES); BROTONS GISBERT, Mauro, 46010 València (ES); ANDRÉS PENARES, Daniel, 46010 València (ES); ELEDATH CHANGARATH, Mahesh, 46010 València (ES); KRECMAROVA, Marie, 46010 València (ES)
(74) Representative: Torner, Juncosa I Associats, SL

(57) **Abstract**

An electronic device is proposed. It comprises an insulating substrate; a multi-terraced nanosheet; and an electrode deposited over each terrace of the multi-terraced nanosheet. The multi-terraced nanosheet comprises at least three terraces, such that a first electrode is deposited over a first terrace, a second electrode is deposited over a second terrace, and a third electrode is deposited over a third terrace. The first terrace and the third terrace have similar thickness, which are thinner or thicker than 10 nanometers, and the second terrace has a different thickness. The first electrode is configured to act as collector and the third electrode is configured to act as emitter, or vice versa, and the second electrode is configured to act as base, whose length is substantially equal to a diffusion length of charge carriers.

## Description

### TECHNICAL FIELD

The present invention generally relates to semiconductor nanoelectronic devices. More specifically, it relates to an electronic device than can operate as a junction or nano-transistor device.

### BACKGROUND OF THE INVENTION

To face challenging requirements raised by current data processing and management, such as the Internet of Things, the continuous miniaturization of Si-based microelectronics has driven the exponential growth of integrated circuits. In consequence, the total number of transistors per chip has been significantly increased. Nevertheless, the miniaturization of Si metal-oxide-semiconductor field-effect-transistors (MOSFETs) has reached the 10 nm length-size technology barrier, following the Moore's Law, where further size-reduction to achieve higher transistor density and performance (i.e., higher speed and lower power consumption) becomes increasingly challenging. The reason of this limitation can be found in the physical limits of bulk materials [1]. Specifically, when the width of the depletion region on the drain terminal in a FET is comparable to the length of the conducting channel, the dynamics of charge carriers are not merely modulated by the gate electric field but also by the drain bias, which contributes to the charge injection by lowering the potential barrier and consequently reducing the threshold voltage as well as increasing the off-state current [2]. Such situation, named short channel effect, causes drastic degradation in the carrier mobility and subthreshold characteristics of the Si-based transistors, together with larger leakage floor and higher static power dissipation that hinder their potential in realizing next-generation electronics.

Two dimensional (2D) semiconductors have been proposed as alternative candidates to push the performance abilities of the current transistor technology below the spatial limit established by channel effect existing in Si MOSFETs, due to their unique atomically thin structure and dangling-bond-free surface. The last decade has witnessed the significant progress in the size scaling of 2D transistors by various approaches, in which the physical gate length of the transistors has shrank from micrometer to sub-one nanometer with superior performance.

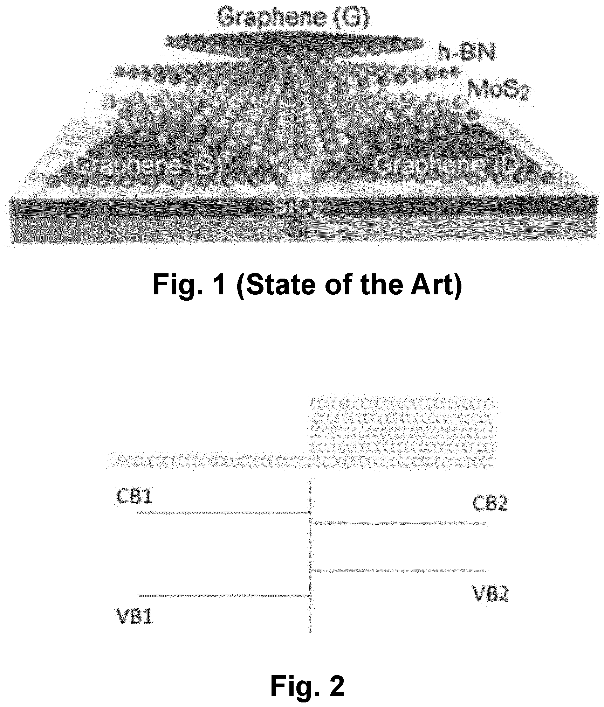

For instance, few layers of transition-metal dichalcogenide (TMD) semiconductors, as MoS₂ and WSe₂, have been used to obtain switching current ratios of up to 10⁸ and excellent subthreshold slope (60 mV/decade) [3,4,5,6,7]. The standard approach of an ideal transistor made by 2D materials (see Fig. 1) would be composed of a TMD material as the channel, with a layered insulator as the gate dielectric, and layered metallic source/drain and gate contacts. By using the same stacking-like approach, atomically thin p-n diodes have been reported, using MoS₂ and WSe₂ monolayers as the electron and hole conducting layers, respectively [8]. These stacked heterostructure diodes have exhibited excellent rectification behavior owing to the abruptness of the 2D-2D interface, with ideality factor of 1.2. MoS₂ transistors with graphene (Gr) source/drain contacts have been used to fabricate flexible, transparent transistors [9]. Also, flexible and transparent MoS₂ transistors with graphene source/drain contacts were fabricated with h-BN as back gate dielectric, demonstrating negligible hysteresis in transport characteristics [10]. Heterostructures with 2D materials have been used for memory applications and tunnel transistors. Gr/MoS₂ heterostructures have been used for nonvolatile memory cells [11]. Tunnel transistors fabricated with Gr/hexagonal-BN (h-BN)/Gr and Gr/MoS₂/Gr open the prospect of obtaining steep transistors with such an architecture [12]. Vertical Gr/h-BN/Gr devices have also exhibited negative differential resistance, allowing the prospect of van der Waals (vdW) heterostructures in analog electronics [13]. Gr/WS₂/Gr heterostructures have demonstrated strong light-matter interactions, leading to enhanced photon absorption and electron-hole creation [14]. This has opened the possibility of flexible photovoltaic devices with layered 2D materials. Heterobilayers of WSe₂ and MoS₂ have shown strong interlayer coupling with spatially direct absorption and spatially indirect emission, exhibiting yet another unique property of TMD heterostructures. TMDC heterojunctions with III-V, Si, and carbon nanotubes have also been explored previously, demonstrating electrically active interfaces built from highly dissimilar semiconductors [15,16,17,18]. Even transistors made completely from two dimensional materials to leverage the absence of interface states with digitally controlled and atomically uniform thickness has been reported [19], with high on-off current ratios.

Two-dimensional devices based on TMDs have demonstrated outstanding properties for electronics and optoelectronics as has been evidenced above. However, some facts reduce the versability of 2D TMD related devices and consequently limit their incorporation into the technological market. As it has been widely reported, the bandgap of TMDs increases as their thickness is reduced due to quantum confinement effects [20,21,22]. Among the most studied compounds of the TMD family (WSe₂, MoSe₂, MoS₂, and WS₂), the highest bandgap increase achieved by sample thinning has been found in WS₂ (from 1.3 eV in the bulk to 1.7 eV in the bilayer and 2.0 eV in the monolayer [23,24]). Such a bandgap window offers interesting possibilities for optoelectronics, but competitive built-in barrier values for modern electronic technologies can be only obtained between the bulk and the monolayer (as a reference, the built-in potential barrier of silicon is about 0.7 eV). Moreover, quantum-size confinement effects achieve the tuning of the bandgap of few-layer TMD nanosheets, but only atomically thin TMDs exhibit photoluminescence due to an indirect to-direct character transition occurring at the monolayer [20,21,22]. This fact makes that all optoelectronic devices based on 2D TMDs require the use (or combination) of monolayer samples. Another important fact that hampers the incorporation of 2D TMDs into competitive electronic devices is the low carrier mobilities of TMDs (of about ~100 cm2/Vs) [25], is a consequence of the intrinsically localized nature and orbital character of the d-states that dominate their valence and conduction bands [21,26].

With a view to the potential applications of 2D semiconductors in nanoelectronics, other candidates, with stronger quantum-confinement effects and higher effective masses, may become competitive. However, few layered semiconductors have valence and conduction bands coming from more delocalized s- and p-orbitals. Indium selenide (InSe), a layered semiconductor of the III-VI family with a direct band gap of -1.25 eV at room temperature [27], is one of these exceptions, since its lowermost conduction band basically stems from antibonding In s states whereas its uppermost valence band has a nonbonding Se-p_{z} orbital character [28]. On top of these electronic properties, InSe is exfoliable and chemically stable [29], and presents the highest electron mobility among layered semiconductors (~10³ cm²/Vs at room temperature) [30], and has an anomalous electron effective-mass anisotropy (m*_{e,∥c}/m*_{e,⊥c}. = 0.081/0.138, where the c-axis is perpendicular to the layer plane) [31]. The confluence in a single material of such characteristics and applicability allows to envisage 2D InSe to become a very versatile material for electronics with tunable and optimized functionalities. In fact, it has been demonstrated that 2D InSe nanosheets exhibit carrier mobilities as high as these of their bulk counterpart [32], strong quantum-confinement effects are able to tune the InSe band gap from 1.25 eV in bulk, to 1.6 in the four-layer and 2.1 eV in the monolayer [33,34]

With these perspectives, 2D InSe seems to be called to break established paradigms in nanoelectronics. It has been recently reported in Nature the realization of a Field Effect Transistor (FET) with 2D InSe with high thermal velocity as channel material that operates at 0.5 V and achieves record high transconductance of 6 mS·µm⁻¹ and a room temperature ballistic ratio in the saturation region of 83% [35], surpassing those of any reported silicon FETs. An yttrium doping-induced phase-transition method is developed for making ohmic contacts with InSe and the InSe FET is scaled down to 10 nm in channel length. The realized InSe FET has appeared to effectively suppress short-channel effects with a low subthreshold swing of 75 mV per decade and drain-induced barrier lowering of 22 mV/V. Furthermore, low contact resistance of 62 Ω·µm is reliably extracted in 10-nm ballistic InSe FETs, leading to a smaller intrinsic delay and much lower energy-delay product (EDP) than the predicted silicon limit.

In spite of the known solution, new and improved electronic devices capable of operating as (nano- or junction) transistor devices are therefore needed.

### References:

[1] K.J. Kuhn, et al., (invited) ECS Trans. 33, 3-17 (2010).
[2] G. Hiblot IEEE Trans. Electron Devices 65, 4015-4018 (2018).
[3] H. Fang, et al., Nano Lett. 13, 1991-1995(2013).
[4] H. Fang, et al., Nano Lett. 12, 3788-3792 (2012).
[5] B. Radisavljevic, et al., ACS Nano 5, 9934-9938 (2011).
[6] S. Chuang,et al., Nano Lett. 14, 1337-1342 (2014).
[7] S. Das, et al., Nano Lett. 13, 100-105 (2013).
[8] B. W. H. Baugher, et al., Nat. Nanotechnol. 9, 262-267 (2014).
[9] J. Yoon, et al., Small 9, 3295-3300 (2013).
[10] G.-H. Lee, et al., ACS Nano 7, 7931- 7936 (2013).
[11] S. Bertolazzi, et al., ACS Nano 7, 3246-3252 (2013).
[12] L. Britnell, et al., Science 335, 947-950 (2012).
[13] L. Britnell, et al., Nat. Commun. 41794 (2013).
[14] T. Georgiou, et al., Nat. Nanotechnol 8, 100-103 (2013).
[15] S. Chuang, et al., Appl. Phys. Lett. 102, 242101 (2013).
[16] G. A. Rance, et al., ACS Nano 4, 4920-4928 (2010).
[17] L. A. Ponomarenko, et al., Nat. Phys. 7, 958-961 (2011).
[18] C. R. Dean, et al., Nat. Nanotechnol. 5, 722-726 (2010).
[19] T. Roy, et al., ACS Nano 8, 6, 6259-6264 (2014).
[20] K. F. Mak, et al., Phys. Rev. Lett. 105, 136805 (2010).
[21] A. Splendiani, et al., Nano Lett. 10, 1271-1275 (2010).
[22] S. Tongay, et al., Nano Lett. 12, 5576-5580 (2012).
[23] J. Gusakova, et al., Phys. Status Sol. a 214, 1700218 (2017).
[24] A. Chaves, et al., npj 2D Mater Appl 4, 29 (2020).
[25] S. H. Mir, et al., ACS Omega 5, 14203-14211 (2020).
[26] E. Cappelluti, et al., Phys. 88, 075409 (2013).
[27] J. Camassel, et al., Phys. Rev. B 17, 4718-4725 (1978).
[28] P. Gomes da Costa, et al., Phys. Rev. B 48, 14135-14141 (1993).
[29] M. Brotons-Gisbert, et al., Appl. Surf. Sci. 2015, 354, 453-458 (2015).
[30] A. Segura, et al., Phys. Rev. B 29, 5708-5717 (1984).
[31] E. Kress-Rogers, et al., solid State Commun. 44, 379-383 (1982).
[32] D. A. Bandurin, et al., Nature Nanotech. 12, 223-227 (2017).
[33] J. F. Sanchez-Royo, et al., Nano Res. 7, 1556-156 (2014).
[34] M. Brotons-Gisbert, et al., Nano Lett., 16, 3221-3229 (2016).
[35] J. Jiang, et al., Nature 616, 470-475 (2023).

### DESCRIPTION OF THE INVENTION

To that end, present invention proposes an electronic device that can be operated as a junction or nano-transistor device and that comprises: an insulating substrate, a multi-terraced nanosheet, and an electrode deposited over each terrace of the multi-terraced nanosheet.

Characteristically, in the present invention, the multi-terraced nanosheet comprises at least three consecutive terraces (named here as first, second and third terraces), such that a first electrical contact is made in a first terrace, a second electrical contact is made in a second terrace, and a third electrical contact is made in a third terrace. Likewise, the first terrace and the third terrace have similar thickness (thinner or thicker than 10 nanometers) and the second terrace has a different thickness. Also, the first electrode is configured to act as collector and the third electrode is configured to act as emitter, or vice versa, while the second electrode is configured to act as base, whose length is comparable to the diffusion length of charge carriers.

In some embodiments, the second terrace is thinner than 10 nanometers whereas the first terrace and the third terrace are thinner or thicker than 10 nanometers but in any case thicker than the second terrace, such that the electronic device is configured to form a NPN bipolar transistor.

In some embodiments, the first terrace and the third terrace are thinner than 10 nanometers whereas the second terrace is thinner or thicker than 10 nanometers but in any case thicker than both the first and third terraces, such that the electronic device is configured to form a PNP bipolar transistor.

In the two embodiments mentioned above, the NPN and PNP bipolar transistors, the length of the second terrace is comparable or shorter than the diffusion length of charge carriers of the multiterraced nanosheet (which is around 10 nanometers in InSe at room temperature).

In some embodiments, the multi-terraced nanosheet is made of InSe. Alternatively, other III-VI compounds can be employed instead of InSe (such as GaSe, In₂Se₃, GaTe, and GaS). In some other embodiments, the multi-terraced nanosheet is made of TMDs (MoS₂, WS₂, WSe₂, MoSe₂). In some embodiments it is made of black phosphorus or other layered materials.

The insulating substrate can be made of any insulating material. In a particular embodiment it is made of silicon.

Accordingly, present invention provides for a new electronic device in the semiconductor nanoelectronics field than can operate as a nano-transistor device. Such a new technology of electronic device can be considered, at the same time, as a homojunction -avoiding lattice mismatch problems at the interface- and a heterojunction -since each side of the interface has a different bandgap (see Fig. 2).

### BRIEF DESCRIPTION OF THE DRAWINGS

The previous and other advantages and features will be more fully understood from the following detailed description of embodiments, with reference to the attached figures, which must be considered in an illustrative and non-limiting manner, in which:
Fig. 1. Illustration of a standard transistor configuration made by the (vertical) stacking of 2D materials.
Fig. 2. Illustration of the technology of an embodiment of present invention. Top plot represents a multi-terraced nanosheet composed by two uniform terraces. Bottom plot illustrates band-gap alignment at the interface.
Fig. 3. (a)-(b) Scheme of a PNP and NPN transistor, respectively, which could be built up by means of multi-terraced nanosheets, according to different embodiments of the present invention. (c) Multi-terraced nanosheet nanolithography contacted. Terminals potentially acting as emitter, base and collector have been identified.
Fig. 4. (a) Optical image of a single-terrace InSe nanosheet. (b) I(V) characteristic of the nanosheet shown in (a), for different illumination conditions. These curves represent a sample that behaves as a resistance, (c) Optical image of a multi-terraced nanosheet. (d) I(V) characteristic of the nanosheet shown in (c), measured under different illumination conditions. These curves represent a diode p-n (like) behavior.

### DETAILED DESCRIPTION OF THE INVENTION AND OF PREFERRED EMBODIMENTS

Present invention provides for an electronic device having an insulating substrate, a multi-terraced nanometric-thick nanosheet, with consecutive terraces of different thicknesses, and an electrode deposited over each terrace. Particularly, the multi-terraced nanosheet is made of InSe (not limitative as in other embodiments it can be made of alternative materials such as dichalcogenide materials, black phosphorus or III-Vi compounds) and comprises three or more terraces.

In the proposed electronic device, the electrode deposited on a first terrace acts as collector and the electrode deposited on a third terrace acts as emitter, or vice versa. The electrode deposited on a second terrace acts as base. The length of the second terrace (or base terminal), that is, the distance between the emitter and collector, is comparable to the diffusion length of charge carriers. Particularly, the length of the base terminal is approximately 10-200 nanometers.

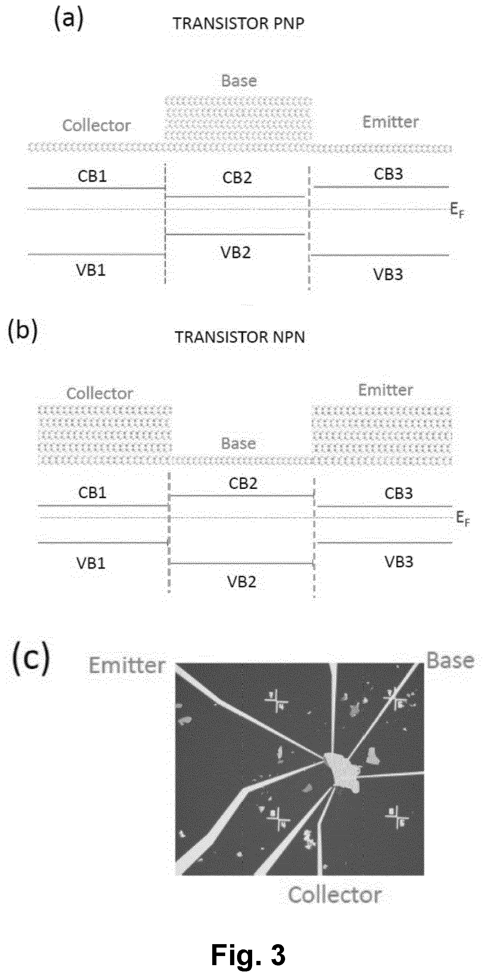

In Fig. 3, different embodiments of the proposed electronic device are illustrated. In Fig. 3(a), the electronic device is configured to form a PNP bipolar transistor, whereas in Fig. 3(b), the electronic device is configured to form an NPN bipolar transistor. In both figures, "CB" stands for conduction band, while "VB" stands for valence band.

In the PNP configuration, the first terrace and the third terrace are thinner than 10 nanometers and the second terrace is thinner or thicker than 10 nanometers but in any case thicker of the first and third terraces.

In the NPN configuration, the second terrace is thinner than 10 nanometers and the first terrace and the third terrace are thinner or thicker than 10 nanometers but in in any case thicker than the second terrace.

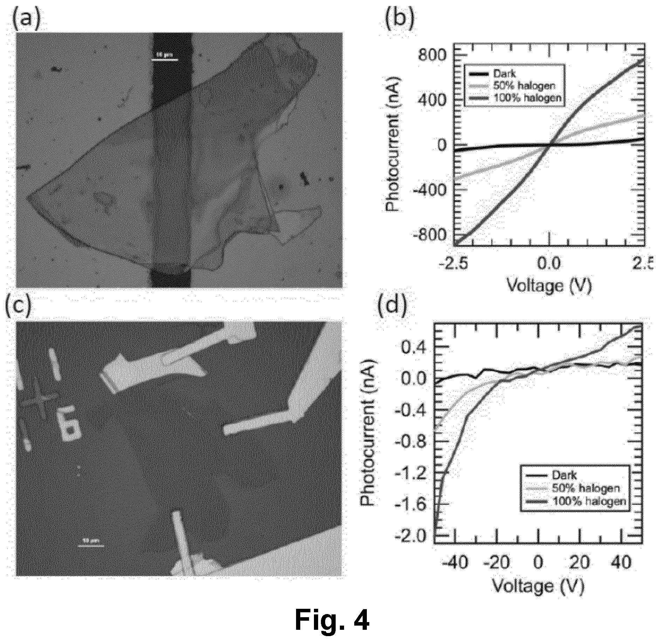

Fig. 4 shows some results obtained from a specific embodiment of the proposed electronic device featuring a multi-terraced InSe nanosheet.

The scope of the present invention is defined in the following set of claims.

## Claims

1. An electronic device, comprising:
an insulating substrate;
a multi-terraced nanosheet; and
an electrode deposited over each terrace of the multi-terraced nanosheet;
**characterized in that:**
the multi-terraced nanosheet comprises at least three terraces, such that a first electrode is placed in a first terrace, a second electrode is placed over a second terrace, and a third electrode is placed over a third terrace;
the first terrace and the third terrace have similar thickness, which are thinner or thicker than 10 nanometers, and the second terrace has a different thickness;
the first electrode is configured to act as collector and the third electrode is configured to act as emitter, or vice versa, and the second electrode is configured to act as base, whose length is comparable to a diffusion length of charge carriers.

2. The electronic device of claim 1, wherein the second terrace is thinner than 10 nanometers and the first terrace and the third terrace are thicker than the second terrace, such that the electronic device is configured to form a NPN bipolar transistor.

3. The electronic device of claim 1, wherein the first terrace and the third terrace are thinner than 10 nanometers, and the second terrace is thinner or thicker than 10 nanometers but in any case thicker than both the first and third terraces, such that the electronic device is configured to form a PNP bipolar transistor.

4. The electronic device of any one of the previous claims, wherein the length of the second terrace is comprised between 10-200 nanometers.

5. The electronic device of any one of the previous claims, wherein the multi-terraced nanosheet is made of Indium Selenide, InSe.

6. The electronic device of any one of the previous claims 1-5, wherein the multi-terraced nanosheet is made of: other III-VI compounds such as GaSe, In₂Se₃, GaTe, and GaS; TMDs compounds such as MoS₂, WS₂, WSe₂, MoSe₂; black phosphorus or other layered materials.

7. The electronic device of any one of the previous claims, wherein the insulating substrate is made of an insulating material.

8. The electronic device of claim 7, wherein the insulating material comprises silicon.
